# FASCICULE DE BREVET EUROPEEN

(11) **EP 0 629 112 B1**
(45) Date de publication et mention de la délivrance du brevet: **21.08.1996**
(21) Numéro de dépôt: 94401259.0
(22) Date de dépôt: 07.06.1994
(51) Int. Cl.: H05K 5/06, B65D 43/00, B65D 45/00

(54) **Dispositif de fermeture de boîtier hermétique à fermeture et ouverture rapides**
Hermetischer Schnellverschluss für einen Behälter
Device for hermetically sealing a casing for fast closure

(30) Priorité: 11.06.1993 FR 9307051
(43) Date de publication de la demande: 14.12.1994
(73) Titulaire: THOMSON-CSF, 75008 Paris (FR)
(72) Inventeur: Bonniau, Philippe, F-92402 Courbevoie Cédex (FR); Chazelas, Jean, F-92402 Courbevoie Cédex (FR)
(74) Mandataire: Chaverneff, Vladimir

(56) Documents cités:
- GB-A- 2 115 614
- GB-A- 2 256 321
- PATENT ABSTRACTS OF JAPAN vol. 009, no. 061 (E-303) 19 Mars 1985 & JP-A-59 200 600

## Description

La présente invention se rapporte à un dispositif de fermeture de boîtier hermétique à fermeture et ouverture rapides.

Un des principaux problèmes posés par les boîtiers métalliques comportant des circuits électroniques, en particulier des circuits hyperfréquences, est d'isoler hermétiquement ces circuits de l'air ambiant. Ces boîtiers sont généralement fabriqués en usinant un bloc de métal pour former un corps de boîtier comprenant une paroi de fond et des parois latérales. On dispose dans ce corps de boîtier les composants et circuits qu'il doit renfermer, et on soude, par exemple par soudure au laser, un couvercle métallique sur ce corps. Or, il arrive souvent que l'on doive régler les composants et circuits de ce boîtier après avoir effectué des mesures qui ne sont valables que lorsqu'il y a un très bon contact électrique entre le couvercle et le corps du boîtier, ce qui ne pouvait être obtenu qu'avec ladite soudure du couvercle. La réouverture de ces boîtiers pour effectuer ces réglages, ou pour pratiquer des opérations de maintenance ou d'échange de composants défectueux, nécessite un dessoudage du couvercle, ce qui est difficile à exécuter sans endommager le boîtier.

La présente invention a pour objet un dispositif de fermeture hermétique de boîtiers, qui permette de fermer et d'ouvrir de nombreuses fois facilement et rapidement ces boîtiers, sans les endommager. L'invention ne se limite cependant pas à de tels boîtiers mais concerne tous les boîtiers présentant une face ouverte sur laquelle est fixée un couvercle.

Le dispositif de fermeture de l'invention, du type à couvercle fixé sur une face ouverte d'un boîtier, comporte au moins un élément en alliage à mémoire de forme appliquant le couvercle sur la face ouverte du boîtier.

Selon un premier mode de réalisation, des ressorts en alliage à mémoire de forme sont disposés entre le couvercle et un contre-couvercle solidarisé au boîtier.

Selon un autre mode de réalisation, le couvercle est en alliage à mémoire de forme, le boîtier comporte un rebord supérieur faisant saillie vers l'intérieur du boîtier, le couvercle étant muni de ressorts en alliage à mémoire de forme sur sa face inférieure et introduit à l'état cintré dans le boîtier, les ressorts prenant appui, à l'état dilaté contre une paroi du boîtier.

La présente invention sera mieux comprise à la lecture de la description détaillée de plusieurs modes de réalisation, pris à titre d'exemples non limitatifs et illustrés par le dessin annexé, sur lequel :
- la figure 1 est une vue en perspective du couvercle d'un premier mode de réalisation d'un dispositif de fermeture conforme à l'invention, ce couvercle étant muni de ressorts extérieurs en alliage à mémoire de forme représentés à l'état court ;
- la figure 2 est une vue en perspective du couvercle de la figure 1, ses ressorts étant à l'état long ;
- la figure 3 est une vue en perspective simplifiée du boîtier sur lequel est appliqué le couvercle de la figure 1 ;
- la figure 4 est une vue en coupe du boîtier de la figure 3 fermé hermétiquement par son couvercle ;
- la figure 5 est une vue en coupe d'une variante de réalisation d'un dispositif de fermeture conforme à l'invention ;
- la figure 6 est une vue en coupe d'un autre mode de réalisation d'un dispositif de fermeture conforme à l'invention, avec fixation rapide du couvercle par vis ;
- les figures 7 à 9 sont des vues en coupe, respectivement du couvercle, du boîtier et de l'ensemble monté pour un autre mode de réalisation du dispositif de fermeture conforme à l'invention, avec fixation du couvercle par rainure-gorge et fil thermo-rétractable de serrage, et
- la figure 10 est une vue en coupe d'un autre mode de réalisation du dispositif de fermeture conforme à l'invention, avec ressorts intérieurs en alliage à mémoire de forme.

L'invention est décrite ci-dessous en référence à un dispositif de fermeture hermétique d'un boîtier métallique tel qu'un boîtier renfermant des circuits électroniques, mais il est bien entendu qu'elle n'est pas limitée à une telle application, et qu'elle peut être mise en oeuvre pour la fermeture rapide, hermétique de divers types d'enceintes métalliques ou non.

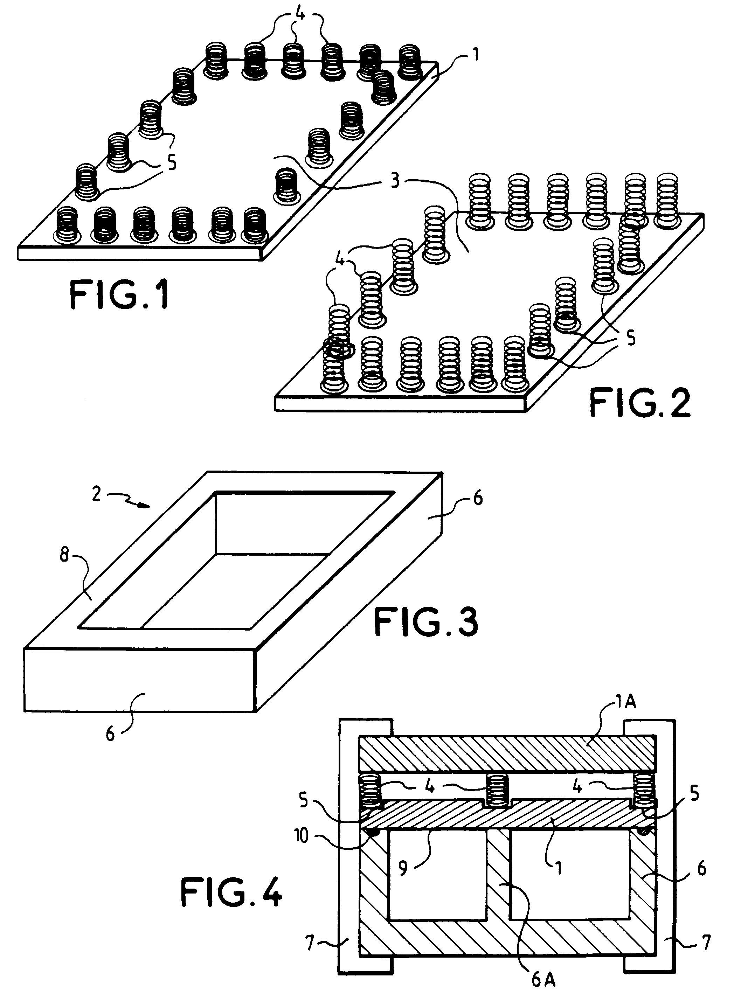

On a représenté en figure 1 le couvercle 1, destiné à assurer la fermeture hermétique d'un boîtier 2 (ce dernier étant visible en figures 3 et 4). Le couvercle 1 est avantageusement souple, et il a une épaisseur d'environ 0,5 mm. Dans le cas de boîtiers pour circuits de microélectronique, le boîtier et le couvercle sont réalisés dans le même matériau, par exemple Ti, Al ou Cu.

La forme du boîtier 2 est ici parallélépipédique, mais il est bien entendu qu'elle peut être quelconque, à condition que sa face supérieure, sur laquelle va être appliqué le couvercle, soit régulière, c'est-à-dire que le couvercle puisse s'adapter facilement à cette face (qui n'est pas nécessairement plane).

Le couvercle 1 est muni sur tout le pourtour de sa face extérieure 3 de ressorts 4 en AMF (alliage à mémoire de forme). Ces ressorts 4 sont collés, brasés, ou fixés par tout moyen approprié sur la face 3 du couvercle 1. Les ressorts 4 sont, de préférence, régulièrement espacés, leur pas étant alors, par exemple de 2 à 10 mm si leur diamètre extérieur est de 1 à 5 mm. Avantageusement, on pratique dans la face 3 des lamages 5 aux emplacements de ces ressorts pour faciliter leur mise en place. Ces lamages ont par exemple une section circulaire dont le diamètre est légèrement supérieur au diamètre extérieur des ressorts, et une faible profondeur (par exemple de 0,1 mm pour un couvercle ayant une épaisseur de 0,5 mm), et ils sont, bien entendu, situés au droit des cloisons latérales 6 du boîtier 2.

De nombreuses études ont été menées dans le monde sur la réalisation d'alliages à mémoire de forme (voir en particulier les articles "Shape Memory Alloys : materials in action" et "General discussion : the use of Shape Memory Actuators" de l'Université Catholique de Louvain).

Les matériaux principalement utilisés sont de type Ni Ti ou des alliages de Cuivre de type Cu-Al-Ni ou Cu-Al-Zn et l'effet mémoire est basé sur une transition de type martensitique, obtenue en faisant varier la température de l'alliage étudié, associée à un changement de forme de l'alliage.

La plage de températures varie d'un type d'alliage à l'autre et est située entre -100 et +200°C environ. Deux types d'effet mémoire sont à distinguer : l'effet mémoire simple sens et l'effet mémoire double sens. L'effet mémoire double sens correspond au passage réversible d'une forme haute température à une forme basse température par un simple changement de température.

La réalisation de ressorts, de fils, de plaques en alliages à mémoire de forme, a trouvé de nombreuses applications dans tous les domaines allant de la chirurgie dentaire à l'automobile en passant par les appareils ménagers (les applications potentielles identifiées sont regroupées dans l'article de M. van Humbeek : "From a seed to a need : the growth of shape memory applications in Europe").

Quelques études en particulier au Japon et aux Etats-Unis ont été dédiées à l'utilisation des alliages à mémoire de forme pour la réalisation d'interconnexions de puces électroniques (Raychem Corporation : "Shape Memory effect alloys as an interconnection tehnology for IC packages and PC boards") ou de boîtiers de composants électroniques type PGA (Pin Grid Array - Japonais).

Dans le cas présent, lorsque les ressorts 4 en AMF sont portés à une température inférieure à leur température de transition (on les dispose dans un endroit réfrigéré), ils se contractent (figure 1), ce qui permet l'introduction libre du couvercle 1 entre le boîtier 2 et une contre-plaque 1A (figure 4) rigide rendue solidaire du boîtier 2, par exemple à l'aide d'étriers 7 enserrant le boîtier 2. De façon avantageuse, la température de transition des éléments AMF constituant les ressorts 4 est choisie inférieure à la température ambiante (ou à la plus basse température de fonctionnement ou d'utilisation des composants du boîtier 2).

Lors de la remontée de la température des ressorts 4, ceux-ci tendent à reprendre leur forme initiale dilatée (telle que représentée en figure 2) après avoir franchi ladite température de transition, le couvercle 1 étant placé, comme indiqué en figure 4, entre la contre-plaque 1A et le boîtier 2, les ressorts étant dirigés vers cette contre-plaque. Ces ressorts créent une pression sensiblement uniforme sur le couvercle 1, l'appliquant hermétiquement contre la face supérieure du boîtier 2. Bien entendu, pour assurer une bonne herméticité, il faut que la face supérieure 8 du boîtier 2 et la face inférieure 9 (qui vient s'appliquer contre la face 3) soient régulières et non rugueuses, et que les ressorts 4 soient suffisamment proches les uns des autres. Pour améliorer l'herméticité, on dispose avantageusement un joint entre les faces 8 et 9, par exemple comme représenté sur la figure 4, un joint torique 10 disposé dans une gorge formée dans la face 8.

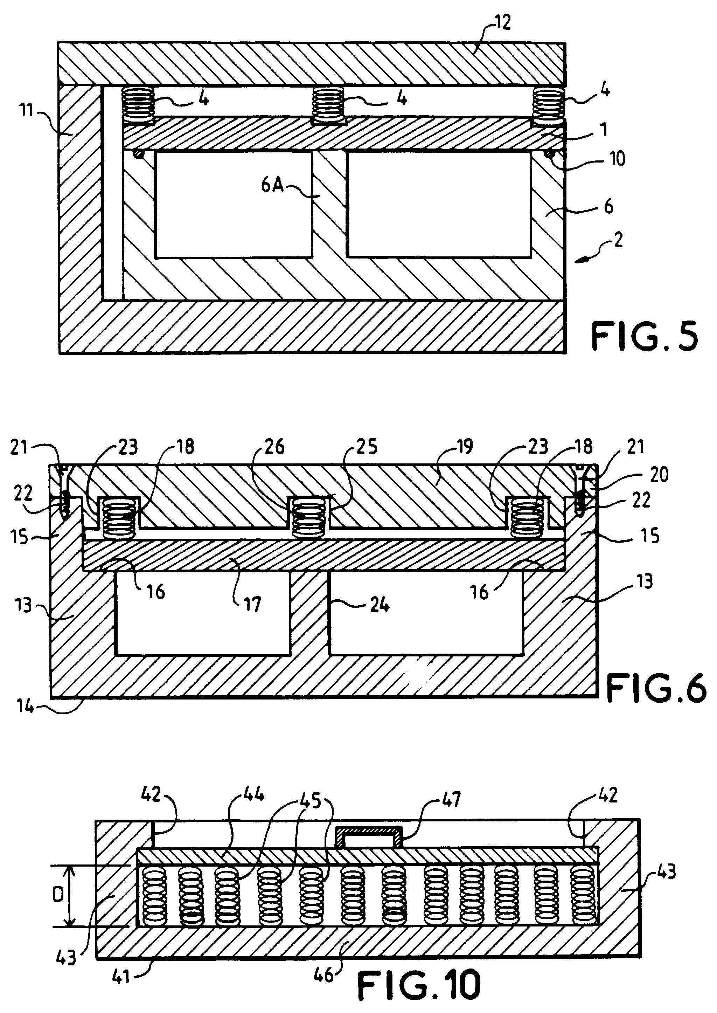

On a représenté en figure 5 une variante du mode de réalisation des figures 1 à 4. Les mêmes éléments sont affectés des mêmes références numériques. Dans cette variante, une contre-plaque 11 à section en "U" entoure le boîtier 2 et son couvercle 1, la distance entre le couvercle 1 et la branche supérieure 12 de la contre-plaque 11 est inférieure à la longueur des ressorts 4 détendus (portés à la température ambiante), mais légèrement supérieure à la longueur de ces mêmes ressorts comprimés (refroidis à une température inférieure à leur température critique). Ainsi, à la température ambiante, les ressorts 4 appliquent hermétiquement le couvercle 1 contre le boîtier 2 en s'appuyant sur la branche 12. Dans ce mode de réalisation, comme dans celui des figures 1 à 4, s'il y a une cloison interne (6A), on peut prévoir dans la face supérieure du couvercle 1 des lamages supplémentaires au droit de cette cloison pour y fixer d'autres ressorts 4 en AMF afin d'assurer un bon contact électrique entre le couvercle 1 et cette cloison 6A. Toutefois, si comme c'est généralement le cas, il n'y a pas besoin d'assurer une herméticité entre les deux compartiments du boîtier 2 délimités par la cloison 6A, les lamages relatifs à cette cloison peuvent être plus espacés que les autres lamages (relatifs aux parois 6).

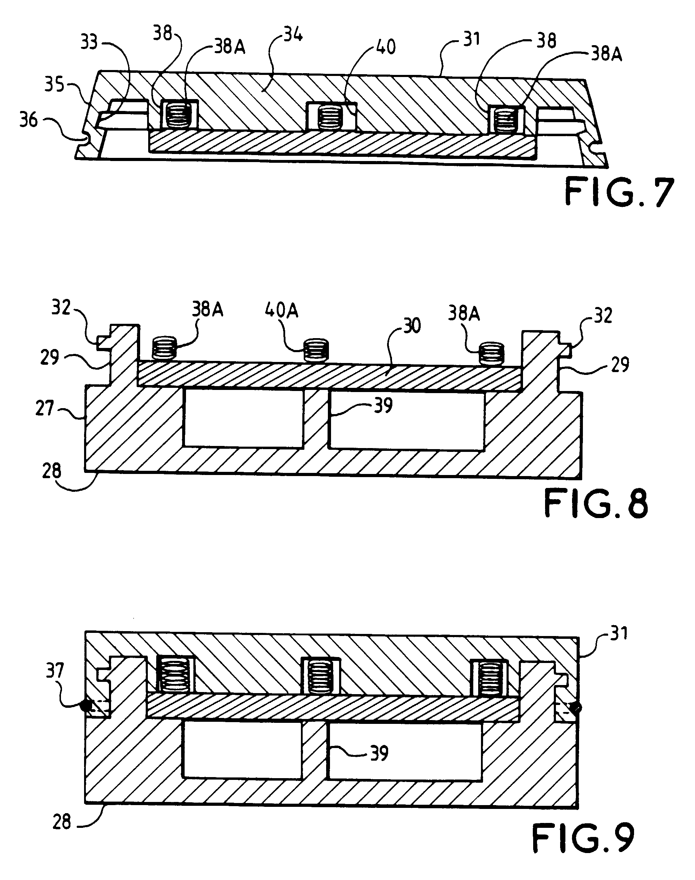

On a représenté en figure 6 un mode de réalisation d'un ensemble autonome boîtier/couvercle/contreplaque conforme à l'invention. Dans cet ensemble, les parois latérales 13 du boîtier 14 comportant un prolongement 15 légèrement moins épais que les parois 13. Les faces extérieures du prolongement 15 sont coplanaires avec les faces extérieures des parois 13, ce qui fait que l'on obtient ainsi sur la face supérieure des parois 13 un rebord 16 sur lequel vient se placer le couvercle souple 17, qui est maintenu latéralement par ce prolongement 15.

La fermeture hermétique du boîtier 14 par le couvercle 17 est obtenue à l'aide d'un contre-couvercle 19 sur lequel sont fixés des ressorts 18. La face inférieure du contre-couvercle 19 présente un contour de mêmes forme et dimensions que l'ouverture du prolongement 15, de façon à s'engager dans cette ouverture à faible jeu. Le contre-couvercle 19 comporte à sa périphérie supérieure un rebord 20 qui vient s'appuyer sur la face supérieure du prolongement 15. La hauteur du prolongement 15 est à peu près égale à la somme des épaisseurs du couvercle 17 et des ressorts 18 (similaires aux ressorts 4) à l'état comprimé. Le contre-couvercle rigide 19 est fixé par un dispositif de fixation rapide sur le prolongement 15. Dans le mode de réalisation représenté sur le dessin, ce dispositif de fixation rapide est constitué par exemple de quatre vis 21 passant dans des trous pratiqués par exemple dans les coins du rebord 20 du couvercle 19 (supposé alors être, comme le boîtier 14, de forme sensiblement rectangulaire) et vissées dans des trous filetés 22 pratiqués dans les coins correspondants, éventuellement localement épaissis, du prolongement 15.

Les vis 21 assurent la fixation rapide du contre-couvercle 19 sur le boîtier 14 (il n'y a que par exemple quatre vis à visser, alors que le nombre de ressorts 18 est nettement plus élevé : plusieurs dizaines).

Sur tout le pourtour de la face inférieure du contre-couvercle 19, près de sa périphérie, on pratique des lamages 23, avantageusement régulièrement espacés, dans lesquels on fixe les ressorts 18. Si, comme représenté sur la figure 6, le boîtier comporte une cloison interne 24, on peut pratiquer dans la face inférieure de la contre-plaque 19, au droit de cette cloison 24, des lamages 25 dans lesquels on fixe des ressorts 26 en AMF semblables aux ressorts 18. Toutefois, si, comme c'est généralement le cas, il n'y a pas à assurer d'étanchéité entre les deux compartiments du boîtier 14 séparés par la cloison 24, mais seulement un très bon contact électrique entre le couvercle 17 et la cloison 24 (ce qui est nécessaire en hyperfréquences en particulier), les lamages 25 peuvent être plus espacés que les lamages 23.

Dans le mode de réalisation des figures 7 à 9, les côtés latéraux 27 du boîtier 28 se terminent par un prolongement 29 plus mince que ces côtés. Ce prolongement 29 est en retrait par rapport aux faces intérieures des côtés latéraux 27, formant ainsi un épaulement assurant le positionnement latéral du couvercle 30 sur la face supérieure des côtés latéraux 27. Le prolongement 29 est également en retrait par rapport aux faces extérieures des côtés latéraux 27 afin de permettre au contre-couvercle 31 de ne pas dépasser de ces faces extérieures. De plus, on forme sur la face extérieure du prolongement 29 une nervure ou languette 32 coopérant avant une rainure correspondante 33 pratiquée dans le contre-couvercle 31 afin de mieux retenir celui-ci sur le boîtier 28. Bien entendu, la rainure peut être pratiquée dans le prolongement 29 et la languette dans le contre-couvercle 31.

Le contre-couvercle 31 comporte un corps 34 se présentant comme une plaque dont la forme et les dimensions sont les mêmes que celles de la surface délimitée intérieurement par le prolongement 29, de façon à pouvoir s'encastrer à faible jeu à l'intérieur de ce prolongement. Le corps 34 se prolonge à sa périphérie supérieure par une jupe 35 au moins légèrement flexible. Avant montage (figure 7), la jupe 35 occupe une position qui s'écarte légèrement vers l'extérieur par rapport à la perpendiculaire à la plaque 34, afin de permettre la mise en place du contre-couvercle 31 sur le prolongement 29. La jupe 35 comporte à la périphérie de sa face extérieure, près de son bord, une gorge 36, dans laquelle on dispose, lors de la mise en place du contre-couvercle 31, un anneau 37 en AMF. Cet anneau 37 est réalisé de façon à se contracter lorsqu'il est porté à une température supérieure à la température critique de l'AMF le constituant. Cette température critique est choisie légèrement inférieure à la température ambiante. Les dimensions de l'anneau 37 sont telles qu'il puisse être facilement introduit, à l'état "froid" (dilaté) dans la gorge 36 (la jupe 35 étant rabattue vers le prolongement 29 si nécessaire), et qu'à l'état "chaud" (contracté), il pénètre jusqu'au fond de la gorge 36 et applique fortement la jupe 35 contre la face extérieure du prolongement 29, et en particulier la languette 32 dans la rainure 33, ce qui assure une bonne prise du contre-couvercle 31 sur le boîtier 28. Bien entendu, d'autres types d'assemblage du contre-couvercle avec le boîtier sont possibles (en queue d'aronde, par rainure et languette ...).

Comme dans le cas du mode de réalisation de la figure 6, la face inférieure du contre-couvercle 31 comporte le long de la périphérie de son corps 34 des lamages 38 qui sont avantageusement à section circulaire de diamètre légèrement supérieur au diamètre extérieur des ressorts 39A en AMF que l'on y fixe par tout moyen approprié ; par exemple par collage. La profondeur des lamages 38 est légèrement supérieure à la longueur des ressorts à l'état "froid". Les lamages 38, pratiqués près de la périphérie du corps 34, sensiblement au droit des parois 27, sont de préférence équidistants, et leur pas est par exemple d'environ 39A pour des ressorts ayant un diamètre extérieur d'environ 1 à 5 mm. Bien entendu, I'épaisseur du corps 34 du contre-couvercle 31 est supérieur à la longueur des ressorts 39A à l'état "froid". Si, comme représenté sur le dessin, le boîtier 38 comporte une cloison intérieure 39, dont la face supérieure est coplanaire avec la face supérieure de la paroi 27, on peut améliorer le contact électrique entre le couvercle 30 et cette cloison intérieure 39 en pratiquant dans la face inférieure du corps 34, au droit de cette cloison intérieure, des lamages 40 dans lesquels on fixe des ressorts 40A en AMF, similaires aux ressorts 38A. En variante, ces ressorts 38A peuvent être fixés sur la face supérieure du couvercle 30 . Ces lamages 40 n'ont pas besoin d'être aussi rapprochés les uns des autres que les lamages 38 s'il n'y a pas besoin d'assurer, comme c'est généralement le cas, une herméticité entre les deux compartiments du boîtier 28 délimités par cette cloison intérieure.

Bien entendu, l'anneau rétractable 37 ne peut convenablement remplir son office que si la cloison 27 a un contour peu anguleux. Dans le cas où le boîtier est sensiblement parallélépipédique, les coins de la cloison 27 doivent être arrondis, et la jupe 35 a évidemment la même forme arrondie dans les coins correspondants.

On a représenté en figure 10 un mode de réalisation du dispositif de fermeture de l'invention ne nécessitant ni de contre-couvercle ni d'outil en étrier ou en "U" (comme dans le cas des figures 4 et 5), plus particulièrement adapté à des boîtiers de forme circulaire ou sensiblement circulaire.

Selon ce mode de réalisation, le boîtier 41 comporte à sa partie supérieure un court rebord 42 perpendiculaire à ses parois latérales 43 et dirigé vers l'intérieur du boîtier. Ce boîtier est fermé par un couvercle 44 en AMF. La forme du couvercle 44 est le même que celle de la section droite intérieure du boîtier 41, à sa partie supérieure au moins, et les dimensions du couvercle 44 sont légèrement inférieures à celles de ladite section droite. Le couvercle 44 est réalisé de façon qu'en-dessous de la température critique du matériau le constituant il soit bombé, sensiblement en forme de calotte sphérique, et qu'au-dessus de cette température critique il soit plan. A l'état bombé du couvercle, son pourtour a des dimensions légèrement inférieures à celles de l'ouverture délimitée par le rebord 42.

On fixe sur la face inférieure du couvercle 44 des ressorts 45, en AMF. En-dessous de la température critique (la même que celle du matériau du couvercle) du matériau les constituant, les ressorts 45 sont comprimés, leur longueur étant alors légèrement inférieure à la distance D entre le fond 46 du boîtier 41 et la face inférieure du couvercle 44. Au-dessus de cette température, les ressorts 45 s'allongent, leur longueur étant alors, si leur dilatation n'était pas entravée, nettement supérieure à D.

Le couvercle 44, muni des ressorts 45, est refroidi à une température inférieure à sa température critique, ce qui fait qu'il se bombe, et qu'on peut l'introduire dans l'ouverture du rebord 42. Pour faciliter sa manipulation, on munit le couvercle 44 d'une poignée 47 fixée à peu près au centre de sa face supérieure. Lorsque le couvercle 44 est introduit à l'intérieur du boîtier 41, on le laisse revenir à la température ambiante (ou on le réchauffe, si nécessaire). Dès que la température du matériau AMF du couvercle et des ressorts repasse au-dessus de sa température critique, le couvercle 44 se redresse et devient plan, tandis que les ressorts 45 se dilatent, et appliquent fermement le couvercle 44 contre le rebord 42. Bien entendu, le nombre de ressorts 45 est suffisant pour appliquer hermétiquement le couvercle 44 contre le rebord 42. Pour renforcer l'herméticité, on peut pratiquer dans la face inférieure du rebord 42 une gorge périphérique et y loger un joint d'étanchéité (non représentés). Si le boîtier est profond, on peut prévoir le long de ses faces latérales une paroi, parallèle au fond du boîtier, sur laquelle viennent s'appuyer les ressorts en AMF.

Bien entendu, pour tous les modes de réalisation décrits ci-dessus, l'ouverture du boîtier (hermétiquement fermé par son couvercle) se fait facilement en portant le boîtier, ou au moins les parties en AMF, à une température inférieure à la température critique de l'AMF utilisé.

Bien entendu, si le boîtier doit toujours être utilisé à une basse température (par exemple inférieure à 0° C), ou tout au moins si les périodes où il doit être utilisé se passent uniquement à basse température, on peut réaliser les ressorts précités de façon qu'ils soient contractés au-dessus de la température critique du matériau AMF les constituant, et dilatés au-dessous de cette température. De même, l'anneau 37 (Figure 9) se contractera alors en-dessous de sa température critique, et le couvercle 44 sera alors bombé au-dessus de sa température critique et plan en-dessous de celle-ci.

## Revendications

1. Dispositif de fermeture hermétique de boîtier à fermeture et ouverture rapides, du type à couvercle fixé sur une face ouverte d'un boîtier, caractérisé par le fait qu'il comporte au moins un élément en alliage à mémoire de forme (4, 18, 26, 38A, 40A, 37, 44, 45) appliquant le couvercle (1, 17, 30, 44) sur la face ouverte du boîtier (2, 14, 28, 41).

2. Dispositif selon la revendication 1, caractérisé par le fait que les éléments en alliage à mémoire de forme sont des ressorts (4, 18, 26, 38A, 40A) disposés entre le couvercle et une contre-plaque (1A, 11, 12, 31) solidarisée au boîtier.

3. Dispositif selon la revendication 2, caractérisé par le fait que la contre-plaque (1A) est solidarisée au boîtier à l'aide d'étriers (7).

4. Dispositif selon la revendication 2, caractérisé par le fait que la contre-plaque (11) a une forme en "U" et entoure le boîtier et le couvercle.

5. Dispositif selon la revendication 2, caractérisé par le fait que la contre-plaque (19, 31) est solidarisée au boîtier à l'aide de moyens de fixation rapide (21, 32-33-36-37).

6. Dispositif selon la revendication 5, caractérisé par le fait que les moyens de fixation rapide sont des vis (2), dont le nombre est nettement moins élevé que celui des ressorts.

7. Dispositif selon la revendication 5, caractérisé par le fait que les moyens de fixation rapide comportent un dispositif à rainure (33) et languette (32) dont l'une est formée sur la contre-plaque (31) et l'autre sur le boîtier (29).

8. Dispositif selon la revendication 5 ou 7, caractérisé par le fait que les moyens de fixation rapide comportent un anneau (37) en alliage à mémoire de forme appliquant une partie flexible (35) de la contre-plaque contre le boîtier.

9. Dispositif selon la revendication 1, caractérisé par le fait que le couvercle (44) est en alliage à mémoire de forme, que le boîtier (41) comporte un rebord supérieur (42) formant saillie vers l'intérieur du boîtier, et que le couvercle est muni de ressorts (45) en alliage à mémoire de forme sur sa face inférieure et est introduit à l'état cintré dans le boîtier, les ressorts prenant appui, à l'état dilaté, contre une paroi du boîtier (46).

## Patentansprüche

1. Vorrichtung zum hermetischen Verschließen eines schnell zu verschließenden und zu öffnenden Gehäuses, die vom Typ mit an einer geöffneten Seite eines Gehäuses befestigten Deckel ist, dadurch gekennzeichnet, daß sie wenigstens ein Element (4, 18, 26, 38A, 40A, 37, 44, 45) aus einer Legierung mit Formerinnerungsvermögen enthält, welches den Deckel (1, 17, 30, 44) auf die geöffnete Seite des Gehäuses (2, 14, 28, 41) drückt.

2. Vorrichtung nach Anspruch 1, dadurch gekennzeichnet, daß die Elemente aus einer Legierung mit Formerinnerungsvermögen Federn (4, 18, 26, 38A, 40A) sind, die zwischen dem Deckel und einer am Gehäuse befestigten Gegenplatte (1A, 11, 12, 31) angeordnet sind.

3. Vorrichtung nach Anspruch 2, dadurch gekennzeichnet, daß die Gegenplatte (1A) am Gehäuse durch Bügel (7) befestigt ist.

4. Vorrichtung nach Anspruch 2, dadurch gekennzeichnet, daß die Gegenplatte (11) eine U-förmige Gestalt hat und das Gehäuse und den Deckel umgibt.

5. Vorrichtung nach Anspruch 2, dadurch gekennzeichnet, daß die Gegenplatte (19, 31) am Gehäuse durch Schnellbefestigungsmittel (21, 32-33-36-37) befestigt ist.

6. Vorrichtung nach Anspruch 5, dadurch gekennzeichnet, daß die Schnellbefestigungsmittel Schrauben (2) sind, deren Anzahl deutlich geringer als die Anzahl der Federn ist.

7. Vorrichtung nach Anspruch 5, dadurch gekennzeichnet, daß die Schnellbefestigungsmittel eine Vorrichtung mit Nut (33) und Feder (32) enthalten, wobei eines dieser Teile an der Gegenplatte (31) und das andere an dem Gehäuse (29) ausgebildet ist.

8. Vorrichtung nach Anspruch 5 oder Anspruch 7, dadurch gekennzeichnet, daß die Schnellbefestigungsmittel einen Ring (37) aus einer Legierung mit Formerinnerungsvermögen enthalten, der einen flexiblen Abschnitt (35) der Gegenplatte an das Gehäuse drückt.

9. Vorrichtung nach Anspruch 1, dadurch gekennzeichnet, daß der Deckel (44) aus einer Legierung mit Formerinnerungsvermögen besteht, daß das Gehäuse (41) einen oberen Rand (42) aufweist, der zum Inneren des Gehäuses hervorsteht, und daß der Deckel auf seiner Innenseite mit Federn (45) aus einer Legierung mit Formerinnerungsvermögen versehen ist und im gewölbten Zustand in das Gehäuse eingebracht wird, wobei sich die Federn im ausgedehnten Zustand an einer Wand (46) des Gehäuses abstützen.

## Claims

1. Device for the airtight closing of fast open-and-close packages of the type with a lid fixed to an open face of a package, characterized in that it comprises at least one shape memory alloy element (4, 18,26, 38A, 40A, 37, 44, 45) applying the lid (1, 17, 30, 44) to the open face of the package (2, 14, 28, 41).

2. Device according to Claim 1, characterized in that the shape memory alloy elements are springs (4, 18, 26, 38A, 40A) positioned between the lid and a facing plate (1A, 11, 12, 31) fixedly joined to the package.

3. Device according to Claim 2, characterized in that the facing plate (1A) is fixedly joined to the package by means of brackets (7).

4. Device according to Claim 2, characterized in that the facing plate (11) is U shaped and surrounds the package and the lid.

5. Device according to Claim 2, characterized in that the facing plate (19, 31) is fixedly joined to the package by fast fixing means (21, 32-33-36-37).

6. Device according to Claim 5, characterized in that the fast fixing means are screws (2) whose number is substantially smaller than that of the springs.

7. Device according to Claim 5, characterized in that the fast fixing means comprise a device with groove (33) and tongue (32), one of which is formed on the facing plate (31) and the other on the package (29).

8. Device according to Claim 5 or 7, characterized in that the fast fixing means comprise a ring (37) made of a shape memory alloy applying a flexible part (35) of the facing plate against the package.

9. Device according to Claim 1, characterized in that the lid (44) is made of a shape memory alloy, that the package (41) has an upper shoulder (42) that forms a projection into the package and that the lid is provided with springs (45) made of shape memory alloy on its lower face and is inserted in a curved state into the package, the springs taking support, in the expanded state, against a wall of the package (46).
